# FASCICULE DE BREVET EUROPEEN

(11) **EP 3 670 440 B1**
(45) Date de publication et mention de la délivrance du brevet: **09.04.2025**
(21) Numéro de dépôt: 18215100.1
(22) Date de dépôt: 21.12.2018
(51) Int. Cl.: B81C 99/00, G03F 7/00, C25D 1/00

(54) **PROCÉDÉ DE FABRICATION D'UN COMPOSANT HORLOGER**
VERFAHREN ZUR HERSTELLUNG EINER UHRENKOMPONENTE
METHOD FOR MANUFACTURING A CLOCK COMPONENT

(43) Date de publication de la demande: 24.06.2020
(73) Titulaire: ROLEX SA, 1211 Genève 26 (CH)
(72) Inventeur: CALAME, Florian, 1066 Épalinges (CH); MAEGLI, Alexandra, 1211 Genève 26 (CH); MULTONE, Xavier, 1005 Lausanne (CH)
(74) Mandataire: Moinas & Savoye SARL

(56) Documents cités:
- EP-A1- 2 405 300
- EP-A1- 2 672 319
- EP-A1- 3 260 932
- WO-A1-2017/148394
- CARSTEN ESCHENBAUM ET AL: "Hybrid lithography: Combining UV-exposure and two photon direct laser writing", OPTICS EXPRESS, vol. 21, no. 24, 26 November 2013 (2013-11-26), XP055413901, DOI: 10.1364/OE.21.029921

## Description

La présente invention concerne un procédé de fabrication d'un composant horloger.

La photolithographie est une technologie couramment utilisée pour la fabrication de composants horlogers, permettant particulièrement de former un moule en résine utilisé pour la fabrication des composants horlogers.

Le brevet EP2405300 décrit, par exemple, la réalisation d'un procédé de fabrication d'une pièce métallique à au moins deux niveaux exploitant la technologie de photolithographie.

Le document EP3035125 propose un procédé amélioré de fabrication d'un composant horloger présentant plusieurs niveaux exploitant la technologie de photolithographie.

Le document EP3260932 décrit un procédé de fabrication d'un composant horloger en céramique polycristalline, dans lequel un moule formé par photolithographie est utilisé.

Ces approches de l'état de la technique basées sur une photolithographie dite traditionnelle présentent toutefois l'inconvénient de ne pas permettre la réalisation de toute forme tridimensionnelle, comme des formes complexes à une échelle micrométrique, voire nanométrique. Le document WO 2017/148394 A1 décrit une méthode dans laquelle une résine photosensible est recouverte par un photomasque au cours d'un processus de photolithographie. La résine photosensible exposée fournit alors une structure de support pour l'étape suivante d'écriture laser par absorption à deux photons. Un faisceau laser provenant d'un dispositif d'écriture laser à absorption à deux photons est utilisé pour exposer le contour d'un composant, dans cet exemple le contour de la forme d'une vis de balancier. Une fois que le substrat à motifs a été cuit, la résine photosensible ayant été exposée par le faisceau laser à deux photons le long du contour de la vis de balancier sera réticulée, de manière à former une coquille fermée. La résine photosensible est ensuite développée dans un révélateur, ce qui permet d'obtenir un moule de résine photosensible présentant les caractéristiques géométriques requises pour la vis d'équilibrage. Le substrat est alors prêt à être placé dans une cuve d'électroformage.

Ainsi, la présente invention a pour objet d'améliorer les procédés connus de l'art antérieur et de proposer une solution de fabrication d'un composant horloger tridimensionnel, éventuellement de forme complexe à une échelle micrométrique, voire nanométrique. Elle a aussi pour objet de permettre la fabrication d'un composant horloger avec une grande fiabilité et une grande précision.

A cet effet, l'invention concerne un procédé de fabrication d'un moule pour composant horloger selon la revendication 1. L'invention concerne également un composant horloger selon la revendication 12.

L'invention porte aussi sur un composant horloger en tant que tel.

Ces objets, caractéristiques et avantages de la présente invention seront exposés en détail dans la description suivante de modes de réalisation particuliers faits à titre non-limitatif en relation avec les figures jointes parmi lesquelles :
La figure 1 représente une vue en perspective d'une roue d'ancre réalisée par un procédé de fabrication selon un mode de réalisation de l'invention.
La figure 2 représente une vue en perspective agrandie d'une dent de la roue d'ancre de la figure 1, réalisée par un procédé de fabrication selon un mode de réalisation de l'invention.
Les figures 3 à 8 illustrent les étapes successives d'un procédé de fabrication de la roue d'ancre représentée par les figures 1 et 2 selon un mode de réalisation de l'invention.
La figure 9 représente une vue en perspective d'un composant horloger en forme de cœur réalisé par un procédé de fabrication selon un mode de réalisation de l'invention.
La figure 10 représente une vue en coupe selon un plan A-A du composant horloger de la figure 9.

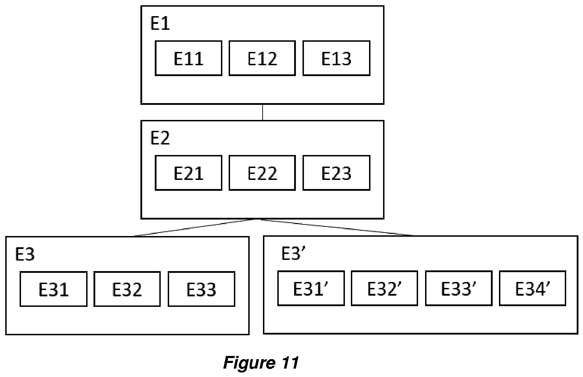

La figure 11 illustre un logigramme représentant schématiquement les étapes et sous-étapes d'un mode de réalisation de l'invention selon deux variantes distinctes.

L'invention met en œuvre un procédé de fabrication d'un composant horloger qui combine avantageusement au moins une étape basée sur une photolithographie traditionnelle et au moins une étape basée sur la technologie de polymérisation à deux photons, connue par son sigle anglo-saxon TPP pour « two-photons polymerization ». Ce procédé est, par exemple, utilisé dans le procédé décrit par le document US9302430, dans un domaine éloigné de l'horlogerie. Il s'apparente finalement à une photolithographie particulière, tridimensionnelle, très différente de la photolithographie traditionnelle.

Plus particulièrement, l'invention met en œuvre un procédé de fabrication comprenant au moins une première étape consistant à fabriquer E1 une première structure sur un substrat, en utilisant la technologie de photolithographie traditionnelle, et une deuxième étape consistant avantageusement à transformer E2 la première structure en une deuxième structure, par une structuration d'au moins une surface de la première structure, notamment en utilisant la technologie de polymérisation à deux photons.

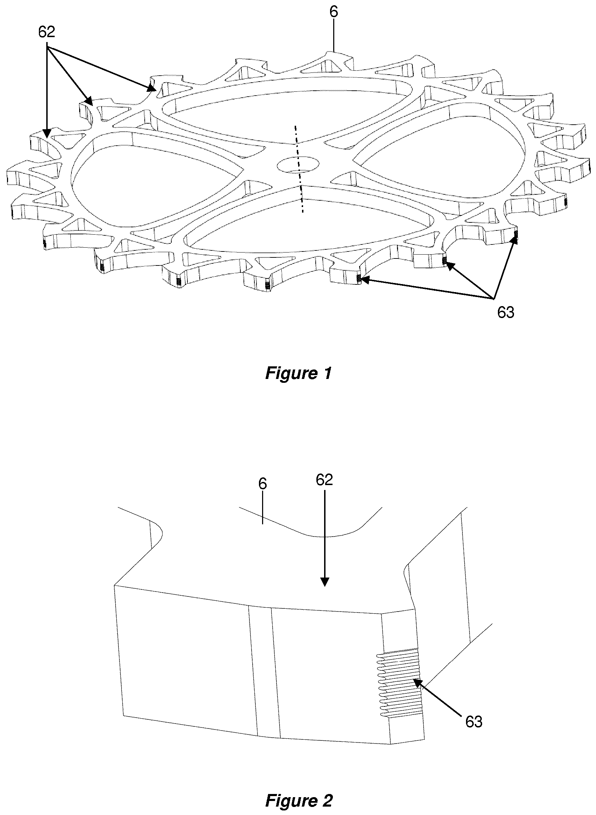

Le procédé de fabrication selon un mode de réalisation de l'invention va être illustré dans le cadre de la fabrication d'une roue d'ancre 6 représentée par les figures 1 et 2. Cette roue d'ancre 6 est, par exemple, réalisée dans un alliage de nickel phosphore (NiP) et comprend des dents 62 comprenant des microstructures 63 au niveau de leurs surfaces de contact, qui sont adaptées pour constituer des canaux de guidage d'un lubrifiant. Cette roue, et notamment les surfaces microstructurées des dents 62, présentent une géométrie très complexe, qui peut avantageusement être obtenue par le procédé de fabrication selon le mode de réalisation qui va maintenant être décrit.

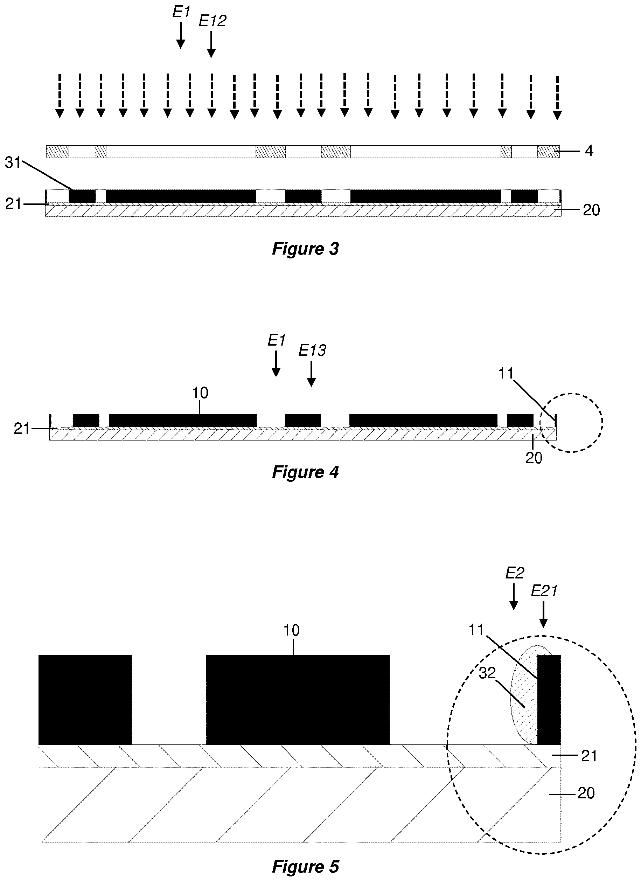

Nous allons, en effet, décrire un mode de réalisation d'un procédé de fabrication d'un composant horloger, en référence avec les figures 3 à 8, particulièrement adapté à la fabrication d'une roue d'ancre telle que décrite ci-dessus, et plus généralement adapté à la fabrication de tout composant horloger.

Selon ce mode de réalisation, le procédé comprend une première étape consistant à fabriquer E1 une première structure 10 sur un substrat 20, en utilisant la technologie de photolithographie traditionnelle.

Par convention, nous définissons la direction horizontale comme une direction parallèle au plan du substrat 20. Nous définissons la direction verticale comme la direction perpendiculaire à la direction horizontale, donc perpendiculaire au plan du substrat.

Ce substrat 20 peut se présenter sous la forme d'une plaquette en métal, comme un acier inoxydable, ou se présenter sous la forme d'une plaquette en silicium, ou en verre ou en céramique. Il est avantageusement plan. Il peut optionnellement comprendre des structures qui sont réalisées, par exemple, par usinage laser. Ces structures peuvent, par exemple, comprendre des motifs, notamment des motifs usinés, et/ou des cavités. Le substrat est préparé selon les règles connues de l'homme de l'art, notamment pour son dégraissage, son nettoyage, éventuellement sa passivation et/ou son activation. Préférentiellement, le substrat 20 est muni de repères de sorte à pouvoir être positionné très précisément. Le substrat 20 peut être fabriqué dans un matériau conducteur, par exemple un acier inoxydable. En variante, on pourrait aussi utiliser un substrat en un matériau non-conducteur, comme par exemple le silicium. Dans ce cas, une couche conductrice 21 peut être déposée sur la surface supérieure du substrat 20, par exemple par évaporation thermique, dans une étape préliminaire mise en œuvre avant la première étape E1. Cette couche conductrice 21 est notamment destinée à jouer le rôle d'électrode pour l'amorçage d'un dépôt galvanique, ou électrodéposition, en vue d'une future croissance métallique du composant, comme cela sera précisé plus loin. De façon connue, cette couche conductrice 21 d'amorçage peut comprendre une sous-couche de chrome, de nickel ou de titane recouverte d'une couche d'or ou de cuivre, et se présenter ainsi sous la forme d'une structure multicouche.

La première étape comprend une sous-étape consistant à déposer E11 une première résine photosensible 31 de sorte à recouvrir tout ou partie de la surface supérieure de la couche conductrice 21 du substrat 20 (ou directement la surface supérieure du substrat 20 en l'absence de couche conductrice 21) d'une couche d'une première résine photosensible 31 sur une hauteur souhaitée, selon les règles connues de l'homme de l'art. Cette première résine photosensible 31 est adaptée à la photolithographie traditionnelle. Elle peut être négative ou positive. Dans le premier cas, elle est conçue pour devenir insoluble ou difficilement soluble à un révélateur sous l'action d'un rayonnement (i.e. les zones exposées résistent au développement), alors que, dans le second cas, elle est conçue pour devenir soluble à un révélateur sous l'action d'un rayonnement, alors que la partie non exposée au rayonnement reste insoluble ou difficilement soluble. Cette résine photosensible 31 peut être de type « SU-8 », qui est une résine photosensible négative qui polymérise sous l'action d'un rayonnement UV, par exemple la résine SU-8-100 de la maison Microchem.

La première étape comprend ensuite une sous-étape consistant à exposer E12 la première résine photosensible 31 à travers un masque 4, notamment par un rayonnement UV, des rayons X ou un faisceau d'électrons, selon une direction sensiblement perpendiculaire au masque, pour la polymériser selon un premier motif défini par le masque 4, comme illustré par la figure 3. Cette exposition consiste à exposer à une radiation lumineuse ou à insoler la couche de résine photosensible 31 à travers le masque 4 comprenant des ouvertures et des zones opaques. Ce masque définit ainsi le premier motif à reproduire pour la réalisation de la structure ou d'une portion de structure. Les rayonnements utilisés sont perpendiculaires ou sensiblement perpendiculaires au plan dans lequel s'étend le masque, et perpendiculaires ou sensiblement perpendiculaires au substrat 20, de manière à n'irradier que les zones de la résine situées au droit des ouvertures ménagées dans le masque. Ces zones sont ainsi définies par des parois verticales ou sensiblement verticales, à savoir perpendiculaires ou sensiblement perpendiculaires au plan du substrat 20. Alternativement, un masque à variation de transmittance peut être employé de sorte à former des parois non verticales ou inclinées.

Ensuite, la première étape comprend une sous-étape consistant à développer E13 la première résine photosensible 31. Dans le cas où la résine 31 est négative, le développement consiste à éliminer les zones de résine non exposées (i.e non insolées), selon un procédé adapté à la résine photosensible 31, par exemple par dissolution avec un produit chimique ou par un procédé plasma. En variante, dans le cas d'une résine photosensible positive, les zones insolées sont éliminées lors du développement par exemple par voie chimique et les zones non insolées sont conservées sur le substrat. Après le développement, le substrat 20 ou l'optionnelle couche conductrice 21 apparaît aux endroits où la résine a été éliminée. Les parties restantes de résine forment ainsi une première structure 10, illustrée par la figure 4. Cette structure repose sur la surface supérieure du substrat 20 ou de l'éventuelle couche conductrice 21 du substrat 20. La première structure 10 s'étend donc entre deux surfaces horizontales, supérieure (définie comme l'interface entre la résine polymérisée et l'air) et inférieure (définie comme l'interface entre la résine polymérisée et la surface supérieure du substrat 20 ou de l'optionnelle couche conductrice 21), et comprend des surfaces latérales 11, s'étendant entre ces deux surfaces horizontales, en général sensiblement verticales mais pouvant être en variante inclinées. Ces surfaces latérales résultent notamment des ouvertures formées dans la première résine photosensible 31 par le retrait de résine photosensible, par la photolithographie traditionnelle. De préférence, la première structure 10 présente une hauteur constante (mesurée entre les deux surfaces supérieure et inférieure).

Afin de créer une structure à plusieurs niveaux, la première étape E1 peut comprendre la répétition des sous-étapes décrites précédemment, avec différents masques, figurant différents sous-premiers motifs, dont la résultante figure la première structure selon un premier motif correspondant à l'association des différents sous-premiers motifs.

Le procédé comprend ensuite une deuxième étape consistant à transformer E2 la première structure 10 en une deuxième structure 1, par la structuration d'au moins une surface de la première structure 10, notamment d'au moins une surface latérale 11 de la première structure 10. Cette étape comprend l'ajout d'un deuxième motif tridimensionnel 12 en résine polymérisée sur ladite au moins une surface.

La deuxième étape comprend ainsi une sous-étape consistant à déposer E21 une couche d'une deuxième résine photosensible 32 liquide ou semi-liquide sur au moins une partie de l'au moins une surface susmentionnée de la première structure 10, notamment une surface latérale 11, comme illustré par la figure 5. Cette étape peut, par exemple, être effectuée par « drop casting » ou tout autre moyen permettant de déposer de la résine liquide ou semi-liquide (« spray coating », « spin coating »...). La deuxième résine photosensible 32 est particulièrement adaptée à la technologie de polymérisation à deux photons mentionnée précédemment. Elle peut être négative ou positive. Dans un mode de réalisation particulier, la résine photosensible 32 utilisée est une résine semi-liquide, par exemple une résine IP-Dip^{™} de la maison Nanoscribe, qui est une résine négative.

Le mode de réalisation ne se limite pas à la description ci-dessus. La surface susmentionnée de la première structure pourrait en variante ou complément être horizontale, et non uniquement une surface latérale, notamment dans le cas d'une fabrication d'un composant horloger multiniveaux.

En variante, les première et deuxième résines photosensibles 31, 32 peuvent être identiques. La résine alors employée pour les deux étapes E1, E2 est adaptée aussi bien à la photolithographie traditionnelle qu'à la technologie de polymérisation à deux photons.

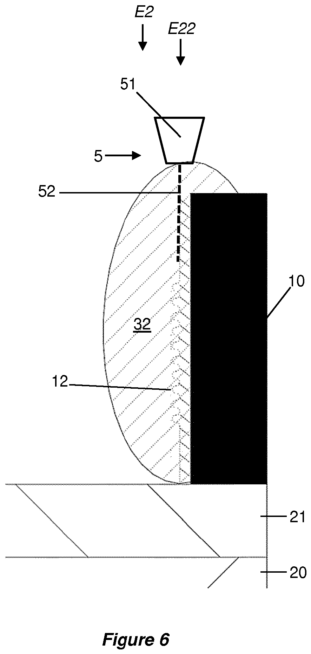

La deuxième étape comprend ensuite une sous-étape consistant à polymériser à deux photons E22 au moins une partie de la couche de la deuxième résine photosensible 32, comme illustré par la figure 6, pour obtenir une polymérisation tridimensionnelle selon un deuxième motif tridimensionnel prédéfini. Pour cela, le procédé peut utiliser un dispositif photonique 5, qui est prévu pour émettre des ondes électromagnétiques sur ou dans la résine photosensible 32, de sorte à la polymériser selon des coordonnées spatiales qui correspondent au deuxième motif. Les intérêts de ce procédé sont la précision de la définition et la complexité des motifs réalisables, comme notamment des motifs non continus selon la direction verticale.

Selon l'invention, le dispositif photonique 5 comporte un objectif 51 qui est au moins partiellement immergé dans la deuxième résine photosensible 32 de sorte à la polymériser selon des coordonnées spatiales définissant la forme ou la géométrie tridimensionnelle 12 du deuxième motif. Une telle variante permet avantageusement d'optimiser la résolution du deuxième motif tridimensionnel. Plus particulièrement, l'objectif 51 est prévu pour diriger et focaliser un faisceau laser 52 de sorte que le point focal passe par les différentes coordonnées spatiales définissant la forme ou la géométrie 12 du deuxième motif. Pour chacune des coordonnées, deux photons peuvent simultanément être absorbés par la résine 32 dans un très petit volume appelé "voxel" au point focal du laser 52. Une réaction chimique est initiée, la résine liquide ou semi-liquide polymérise et devient solide à l'intérieur du voxel. Les voxels résultant du parcours de focalisation du faisceau laser 52 définissent ainsi la forme ou la géométrie 12 du deuxième motif. En combinant avantageusement l'optique de focalisation du laser et le matériau de la résine photosensible 32, le diamètre du voxel peut être inférieur à 0.1 µm, et permet donc de définir des microstructurations voire des nanostructurations de très haute résolution sur la au moins une surface, notamment sur la au moins une surface latérale 11, de la première structure 10. Cette étape permet ainsi de définir un deuxième motif selon une résolution tridimensionnelle inférieure ou égale à 0.001 µm³ et une résolution latérale équivalente au diamètre du voxel, soit inférieure ou égale à 0.1 µm.

D'autre part, comme représenté par la figure 6, ce deuxième motif peut s'étendre au moins en partie dans une direction horizontale, ou présenter une composante horizontale significative, à partir d'un dépôt de deuxième résine photosensible 32 sur une surface latérale 11 de la première structure 10, notamment sur une surface perpendiculaire ou sensiblement perpendiculaire au substrat 20.

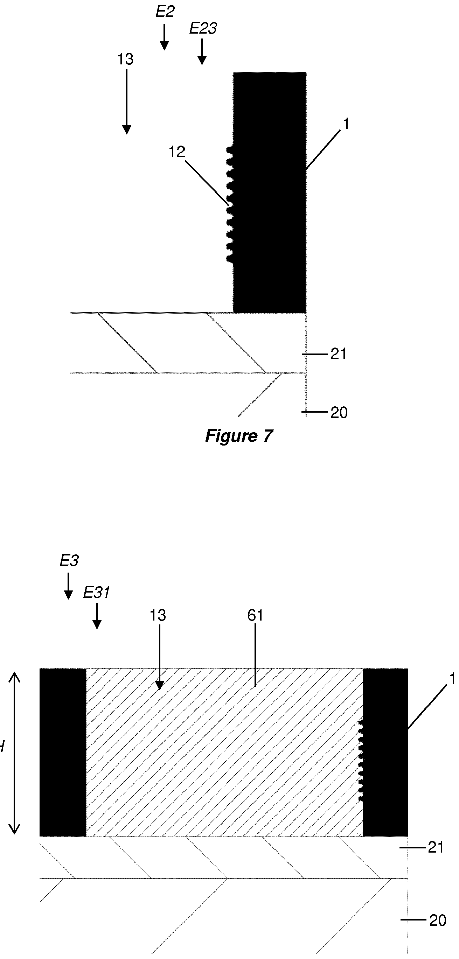

Cette étape peut donc former des microstructurations, voire des nanostructurations, qui peuvent, par exemple, prendre la forme de créneaux ou d'escaliers 12 sur la surface 11, comme illustré par la figure 7. Ces formes ne creusent pas la surface 11, mais sont disposées en relief sur la surface 11.

La deuxième étape comprend ensuite une sous-étape consistant à développer E23 la deuxième résine photosensible 32 pour éliminer la deuxième résine photosensible 32 non polymérisée et obtenir la deuxième structure 1 de forme définie par les premier et deuxième motifs. En effet, une fois la deuxième résine photosensible 32 polymérisée selon la géométrie tridimensionnelle prédéfinie, les zones de résine photosensible 32 non exposées sont éliminées dans le cas d'une résine photosensible négative, par exemple par dissolution avec un produit chimique ou par un procédé plasma. Préférentiellement, le produit chimique utilisé est le même que celui exploité lors de la première étape. Celui-ci peut, par exemple, être un solvant à base de PGMEA.

A la fin de cette deuxième étape, l'assemblage des deux résines photosensibles 31, 32 mises en forme selon respectivement les deux motifs susmentionnés forme finalement une deuxième structure 1 solidaire du substrat 20. Selon le mode de réalisation, cette deuxième structure 1 est destinée à former, complémentairement avec le substrat 20, un moule de fabrication d'un composant horloger. Pour ce faire, elle peut comprendre au moins une cavité 13. Du fait du procédé décrit ci-dessus, il est possible de former une deuxième structure 1 présentant toute forme tridimensionnelle complexe, et donc par conséquent permettant de former tout composant horloger de forme tridimensionnelle complexe correspondante.

Le procédé de fabrication met ensuite en œuvre une troisième étape consistant à utiliser E3 la deuxième structure 1, complémentairement avec le substrat 20, comme moule de fabrication du composant horloger 6. Ce dernier peut notamment être en métal ou alliage métallique, en céramique, notamment en céramique technique ou en matériau composite. Il peut éventuellement être renforcé par des fibres, comme, par exemple, des fibres de carbone ou du kevlar.

Selon une première variante de réalisation, le composant horloger 6 est formé en métal ou en alliage métallique.

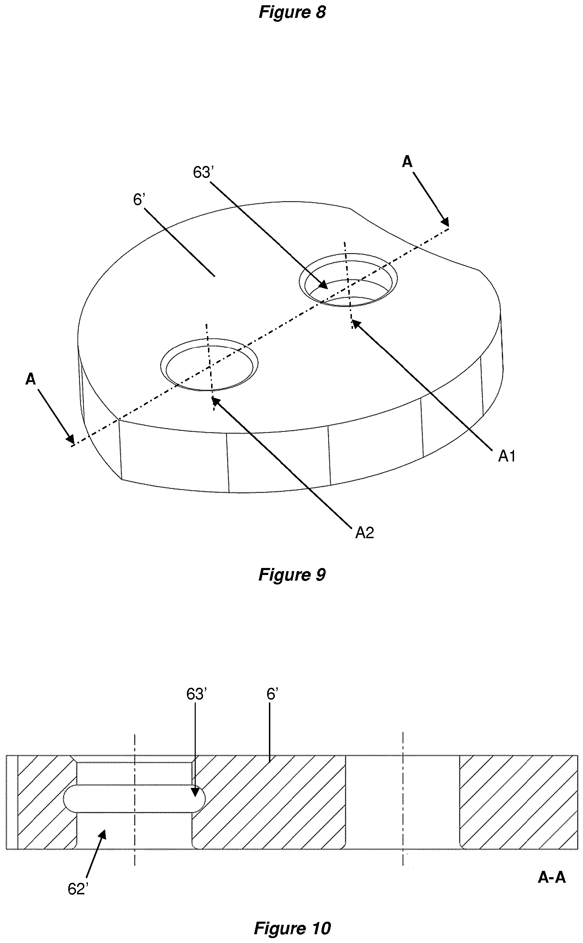

Dans cette première variante de réalisation, la troisième étape comprend une sous-étape consistant à déposer E31 une couche de métal 61 formant le composant horloger, par électrodéposition ou dépôt galvanique, dans la ou les cavités 13 de la deuxième structure 1, comme illustré par la figure 8. Dans cette sous-étape, la couche conductrice 21 susmentionnée ou le substrat 20 lui-même s'il est dans un matériau conducteur, joue le rôle de cathode pour amorcer le dépôt. Cette étape utilise, par exemple, le procédé LIGA et un métal ou un alliage de métal tel que, par exemple, le nickel (Ni) ou le nickel-phosphore (NiP) ou un matériau à base de nickel. Avantageusement, un alliage tel que décrit par le document WO2017102661 peut être employé. La couche de métal 61 obtenue a préférentiellement la même hauteur H que celle du moule formé par la deuxième structure 1. Elle peut aussi avoir une hauteur inférieure à la hauteur du moule, voire une hauteur supérieure à la hauteur du moule. De façon optionnelle, cette sous-étape peut comprendre une mise d'épaisseur, par polissage mécanique simultané de la couche métallique et du moule, pour obtenir une surface supérieure parfaitement plane, horizontale.

Par ailleurs, la couche de métal 61 obtenue a préférentiellement une hauteur H sensiblement supérieure à celle de la couche 21. Elle est préférentiellement supérieure à cinq fois la hauteur de la couche 21, voire supérieure à dix fois la hauteur de la couche 21.

Dans cette première variante de réalisation, la troisième étape comprend une sous-étape consistant à séparer E32 l'ensemble formé par ladite couche de métal 61 et la deuxième structure 1 du substrat 20, par exemple par délamination de la couche conductrice 21 du substrat.

Dans cette première variante de réalisation, la troisième étape comprend une sous-étape consistant à séparer E33 le composant horloger 6, formé par ladite couche de métal 61, de la deuxième structure 1, par exemple par attaque chimique ou à l'aide d'un plasma. On libère ainsi le composant horloger 6.

Les étapes E32 et E33 peuvent être réalisées dans un ordre quelconque.

Selon une deuxième variante de réalisation, le composant horloger 6 est formé en céramique, notamment en céramique technique.

Dans cette deuxième variante de réalisation, la troisième étape comprend une sous-étape consistant à remplir E31' la deuxième structure par voie liquide d'un produit comprenant de la poudre de céramique. Cette étape peut, par exemple, comprendre le coulage d'une barbotine ou le coulage d'un gel ou un coulage de coagulation. Alternativement, cette étape peut être mise en œuvre par électrophorèse dans le cas d'un substrat fait en un matériau conducteur ou dont la surface supérieure du substrat est recouverte d'une couche 21 conductrice. Dans le cas d'une barbotine, cette dernière peut comprendre une matière liquide, de la poudre de céramique et au moins un adjuvant. La matière liquide peut comprendre de l'eau, un alcool ou un autre solvant organique. La poudre de céramique peut, par exemple, comprendre une zircone, ou une alumine, ou un oxyde, ou un carbure, ou un nitrure. Cette étape peut être réalisée sous vide pour garantir un remplissage parfait sans inclusion d'air.

Cette sous-étape E31' peut être précédée par une sous-étape facultative consistant à préparer au moins une portion de surface de substrat 20 en regard d'au moins une cavité 13 de la deuxième structure 1 ou à déposer un revêtement sur au moins une portion de surface de substrat 20 en regard d'au moins une cavité 13 de la deuxième structure 1, dans le but de faciliter la libération future d'une ébauche du composant horloger 6. En remarque, cette ébauche peut, par exemple, prendre la forme du corps vert préfigurant le composant horloger 6.

Dans cette deuxième variante de réalisation, la troisième étape comprend une sous-étape consistant à consolider E32' le produit positionné dans la deuxième structure 1. Cette sous-étape comprend le séchage de la barbotine afin d'obtenir une ébauche du composant horloger 6.

Une sous-étape intermédiaire facultative peut consister en la mise de hauteur de l'ébauche du composant horloger 6, avant libération du moule. Cette ébauche peut, par exemple, prendre la forme du corps vert préfigurant le composant horloger 6.

Dans cette deuxième variante de réalisation, la troisième étape comprend une sous-étape consistant à séparer E33' l'ébauche de composant du moule de fabrication formé par la deuxième structure, et à séparer l'ébauche de composant du substrat 20, ces deux séparations pouvant être réalisées dans un ordre quelconque. Cette séparation peut, par exemple, être réalisée par attaque chimique ou par traitement à l'aide d'un plasma.

Dans cette deuxième variante de réalisation, la troisième étape comprend enfin une sous-étape consistant à délianter l'ébauche obtenue à l'étape précédente puis à la densifier E34' par frittage. Préférentiellement, le substrat 20 est fait en un matériau prévu pour supporter les températures auxquelles sont effectuées les sous-étapes de la troisième étape E3'. Par exemple, le substrat peut être en silicium ou en alumine.

Le procédé de fabrication d'un composant horloger précédemment décrit peut être utilisé pour la fabrication de tous composants horlogers tels que, à titre d'exemples illustratifs et non limitatifs, un balancier, une ancre, un sautoir, un pignon, une roue, une bascule, un ressort, un balancier, une came, ou encore une ébauche. Il peut notamment naturellement être utilisé pour fabriquer tout élément comprenant une microstructure. Les figures 9 et 10 illustrent ainsi un autre exemple de composant horloger, qui prend ici la forme d'un cœur 6'. Ce cœur est préférentiellement réalisé en une céramique technique. Celui-ci comporte un alésage 62', qui comprend une gorge 63'. Avantageusement, une telle gorge 63' est prévue pour contenir un élément prévu pour fixer le cœur sur un canon, comme un circlip par exemple. Cette gorge peut présenter une forme de demi-sphère, comme cela est illustré par les figures 9 et 10. Bien entendu, elle peut présenter toute géométrie. Elle peut, par exemple, présenter une forme asymétrique de sorte à répondre au mieux à des sollicitations de forces ou de couples.

Selon la deuxième variante de réalisation, le composant horloger est préférentiellement fait en une céramique ou en matériau composite. Un tel composant en céramique est préférentiellement en céramique dite technique. Par « céramiques techniques », on désigne les matériaux denses à base d'oxyde d'aluminium ; et/ou d'oxyde de zirconium ; et/ou d'oxyde de zirconium stabilisé notamment avec l'oxyde d'yttrium et/ou l'oxyde de cérium et/ou l'oxyde de magnésium ; et/ou en aluminate de strontium notamment dopé ; et/ou de nitrures ; et/ou de carbures ; et être optionnellement pigmenté notamment par des oxydes métalliques et/ou des oxydes métalliques mixtes et/ou des phases spinelles. Pour simplifier la description, nous pouvons utiliser le terme « céramique » pour désigner les « céramiques techniques » pouvant constituer le composant 6. Par « dense », on considère un matériau dont la densité est comprise entre 95 et 100% de la densité théorique du matériau considéré. On note que la notion « à base de » signifie ici que le composant chimique désigné représente au moins 50% en poids de la composition chimique globale de la céramique concernée.

Il apparaît donc que l'invention atteint les objets recherchés en combinant avantageusement deux technologies différentes. La photolithographie traditionnelle permet de former le volume principal du composant horloger, de manière simple, rapide et fiable par une première étape, et la technologie de polymérisation à deux photons permet d'ajouter des formes complexes à ce volume principal, par une deuxième étape plus complexe et moins rapide mais plus précise et souple, permettant de définir tout motif tridimensionnel. Il en résulte un composant horloger de forme complexe, fabriqué de manière simple et robuste. L'invention porte aussi sur un composant horloger obtenu par le procédé de fabrication décrit précédemment. Ce composant horloger comprend une surface structurée par le deuxième motif de la deuxième structure décrite précédemment. Le composant horloger se présente ainsi sous une forme monobloc comprenant la surface structurée, voire même plus précisément microstructurée ou nanostructurée. Autrement dit, la surface structurée vient de matière avec le reste du composant horloger.

Avantageusement, la surface structurée s'étend au moins en partie sur une surface latérale du composant horloger. La structuration présente des reliefs en creux dans une direction horizontale, ou présentant une composante horizontale significative. La surface structurée présente par exemple des microstructurations, voire des nanostructurations. Ces structurations peuvent, par exemple, prendre la forme de créneaux ou d'escaliers. Elles sont en relief, en creux dans la surface structurée du composant horloger. Cette surface structurée peut de plus être définie avec une grande précision. Notamment, selon l'invention, elle comprend une résolution tridimensionnelle inférieure ou égale à 0.001 µm³ et/ou une résolution latérale (dans la direction horizontale) inférieure ou égale à 0.1 µm.

## Revendications

1. Procédé de fabrication d'un moule pour composant horloger, comprenant au moins les étapes suivantes:
- Fabriquer (E1) une première structure (10) à partir d'une première résine photosensible (31) comprenant au moins une couche de résine photosensible comprenant un premier motif obtenu par polymérisation de la première résine photosensible par irradiation à travers au moins un masque (4), puis développement de ladite première résine photosensible ;
- Transformer (E2) la première structure (10) en une deuxième structure (1) par une structuration d'au moins une surface de la première structure par ajout d'une deuxième résine photosensible (32) sur ladite au moins une surface, ladite deuxième structure (1) étant destinée à former au moins partiellement le moule de fabrication dudit composant horloger, cette étape consistant à transformer (E2) la première structure comprenant les étapes suivantes :
o Déposer (E21) une couche de la deuxième résine photosensible sur au moins une partie de l'au moins une surface de la première structure ;
o Polymériser à deux photons (E22) la deuxième résine photosensible pour obtenir une polymérisation tridimensionnelle selon le deuxième motif, en utilisant un dispositif photonique qui comporte un objectif qui est au moins partiellement immergé dans la deuxième résine pour diriger et focaliser un faisceau sur des voxels définissant la forme ou la géométrie du deuxième motif ;
o Développer (E23) pour éliminer la deuxième résine photosensible non polymérisée et obtenir la deuxième structure de forme définie par les premier et deuxième motifs.

2. Procédé de fabrication d'un moule pour composant horloger selon la revendication précédente, **caractérisé en ce que** l'étape consistant à transformer (E2) la première structure comprend l'ajout de la deuxième résine photosensible sur au moins une surface latérale (11) de la première structure.

3. Procédé de fabrication d'un moule pour composant horloger selon l'une des revendications précédentes, **caractérisé en ce que** l'étape consistant à transformer (E2) la première structure comprend le dépôt (E21) de la deuxième résine photosensible sur ladite au moins une surface, la polymérisation tridimensionnelle (E22) de cette deuxième résine selon un deuxième motif et le développement (E23) de la deuxième résine.

4. Procédé de fabrication d'un moule pour composant horloger selon la revendication 2 ou 3, **caractérisé en ce que** l'étape consistant à polymériser à deux photons (E22) permet de définir un deuxième motif selon une résolution tridimensionnelle inférieure ou égale à 0.001 µm³ et/ou selon une résolution latérale inférieure ou égale à 0.1 µm.

5. Procédé de fabrication d'un moule pour composant horloger selon l'une des revendications précédentes, **caractérisé en ce que** l'étape consistant à fabriquer (E1) la première structure comprend les étapes suivantes :
- Déposer (E11) la première résine photosensible sur la surface supérieure d'un substrat, notamment un substrat sous forme d'une plaquette en métal comme un acier inoxydable, ou en silicium, ou en verre, ou en céramique ;
- Exposer (E12) la première résine photosensible à travers un masque, notamment par un rayonnement UV, des rayons X ou un faisceau d'électrons, selon une direction perpendiculaire ou sensiblement perpendiculaire au masque, pour la polymériser selon le motif défini par le masque ;
- Développer (E13) la première résine photosensible.

6. Procédé de fabrication d'un moule pour composant horloger selon la revendication précédente, **caractérisé en ce que** l'étape consistant à exposer (E12) la première résine génère une première structure comprenant des flancs latéraux perpendiculaires ou sensiblement perpendiculaires au substrat et/ou une section parallèle ou sensiblement parallèle au substrat constante.

7. Procédé de fabrication d'un moule pour composant horloger selon l'une des revendications précédentes, **caractérisé en ce que** :
- Les deux résines sont identiques ou différentes ; et/ou
- Les deux résines sont positives ou négatives ; et/ou
- La première résine est de type « SU-8 » ou de type « SU-8-100 »; et/ou
- La deuxième résine est une résine liquide ou semi-liquide, notamment IP-Dip ^{™}.

8. Procédé de fabrication d'un composant horloger, **caractérisé en ce qu'**il comprend une étape consistant à fabriquer un moule pour composant horloger selon l'une des revendications précédentes, puis une étape consistant à utiliser la deuxième structure dudit moule comme moule de fabrication du composant horloger, notamment en métal ou alliage métallique, en céramique ou en matériau composite.

9. Procédé de fabrication d'un composant horloger selon la revendication précédente, **caractérisé en ce qu'**il comprend les étapes suivantes :
- Déposer (E31) une couche de métal formant le composant horloger, par électrodéposition ou dépôt galvanique dans la deuxième structure ;
- Séparer (E32) le composant horloger, formé par ladite couche de métal, et ladite deuxième structure d'un substrat et séparer (E33) le composant horloger, formé par ladite couche de métal, de ladite deuxième structure.

10. Procédé de fabrication d'un composant horloger selon la revendication précédente, **caractérisé en ce que** le métal est à base de nickel ou est un alliage de nickel-phosphore.

11. Procédé de fabrication d'un composant horloger selon la revendication 8, **caractérisé en ce qu'**il comprend les étapes suivantes :
- Remplir (E31') la deuxième structure par voie liquide d'un produit comprenant de la poudre de céramique ;
- Consolider (E32') ledit produit ;
- Séparer (E33') l'ébauche formée par ledit produit de ladite deuxième structure et d'un substrat ;
- Délianter l'ébauche obtenue à l'étape précédente puis la densifier (E34') par frittage.

12. Composant horloger comprenant deux surfaces horizontales, comprenant une surface structurée, voire microstructurée ou nanostructurée, venant de matière avec le reste du composant horloger, et s'étendant au moins en partie en creux sur une surface latérale du composant horloger, s'étendant entre les deux surfaces horizontales, formant un motif non continu selon la direction verticale perpendiculaire aux surfaces horizontales, **caractérisé en ce que** la surface structurée comprend une structuration de résolution tridimensionnelle inférieure ou égale à 0.001 µm³ et/ou de résolution latérale, dans la direction horizontale, inférieure ou égale à 0.1 µm.

## Patentansprüche

1. Verfahren zur Herstellung einer Form für eine Uhrenkomponente, umfassend mindestens die folgenden Schritte:
- Herstellen (E1) einer ersten Struktur (10) ausgehend von einem ersten lichtempfindlichen Harz (31), die mindestens eine Schicht aus lichtempfindlichem Harz umfasst, die ein erstes Muster umfasst, das durch Polymerisation des ersten lichtempfindlichen Harzes durch Bestrahlung durch mindestens eine Maske (4) hindurch erhalten wird, dann Entwickeln des ersten lichtempfindlichen Harzes;
- Umwandeln (E2) der ersten Struktur (10) in eine zweite Struktur (1) durch eine Strukturierung mindestens einer Oberfläche der ersten Struktur durch Hinzufügen eines zweiten lichtempfindlichen Harzes (32) zu der mindestens einen Oberfläche, wobei die zweite Struktur (1) dazu bestimmt ist, mindestens teilweise die Form zur Herstellung der Uhrenkomponente zu bilden, wobei dieser Schritt, der darin besteht, die erste Struktur umzuwandeln (E2), die folgenden Schritte umfasst:
o Abscheiden (E21) einer Schicht des zweiten lichtempfindlichen Harzes auf mindestens einem Teil der mindestens einen Oberfläche der ersten Struktur;
o Durchführen einer Zwei-Photonen-Polymerisation (E22) des zweiten lichtempfindlichen Harzes, um eine dreidimensionale Polymerisation gemäß dem zweiten Muster zu erhalten, unter Verwendung einer photonischen Vorrichtung, die ein Objektiv umfasst, das mindestens teilweise in das zweite Harz eingetaucht ist, um einen Strahl auf Voxel zu richten und zu fokussieren, die die Form oder die Geometrie des zweiten Musters definieren;
o Entwickeln (E23), um das nicht polymerisierte zweite lichtempfindliche Harz zu entfernen und die zweite Struktur mit der durch das erste und das zweite Muster definierten Form zu erhalten.

2. Verfahren zur Herstellung einer Form für eine Uhrenkomponente nach dem vorhergehenden Anspruch, **dadurch gekennzeichnet, dass** der Schritt, der darin besteht, die erste Struktur umzuwandeln (E2), das Hinzufügen des zweiten lichtempfindlichen Harzes zu mindestens einer seitlichen Oberfläche (11) der ersten Struktur umfasst.

3. Verfahren zur Herstellung einer Form für eine Uhrenkomponente nach einem der vorhergehenden Ansprüche, **dadurch gekennzeichnet, dass** der Schritt, der darin besteht, die erste Struktur umzuwandeln (E2), das Abscheiden (E21) des zweiten lichtempfindlichen Harzes auf der mindestens einen Oberfläche, die dreidimensionale Polymerisation (E22) dieses zweiten Harzes gemäß einem zweiten Muster und das Entwickeln (E23) des zweiten Harzes umfasst.

4. Verfahren zur Herstellung einer Form für eine Uhrenkomponente nach Anspruch 2 oder 3, **dadurch gekennzeichnet, dass** der Schritt, der darin besteht, die Zwei-Photonen-Polymerisation durchzuführen (E22), es ermöglicht, ein zweites Muster gemäß einer dreidimensionalen Auflösung kleiner als oder gleich 0,001 µm³ und/oder gemäß einer seitlichen Auflösung kleiner als oder gleich 0,1 µm zu definieren.

5. Verfahren zur Herstellung einer Form für eine Uhrenkomponente nach einem der vorhergehenden Ansprüche, **dadurch gekennzeichnet, dass** der Schritt, der darin besteht, die erste Struktur herzustellen (E1), die folgenden Schritte umfasst:
- Abscheiden (E11) des ersten lichtempfindlichen Harzes auf der oberen Oberfläche eines Substrat, insbesondere eines Substrats in Form eines Plättchens aus Metall wie ein Edelstahl oder aus Silicium oder aus Glas oder aus Keramik;
- Belichten (E12) des ersten lichtempfindlichen Harzes durch eine Maske hindurch, insbesondere mit einer UV-Strahlung, Röntgenstrahlen oder einem Elektronenstrahl, gemäß einer senkrecht oder im Wesentlichen senkrecht zu der Maske verlaufenden Richtung, um es gemäß dem durch die Maske definierten Muster zu polymerisieren;
- Entwickeln (E13) des ersten lichtempfindlichen Harzes.

6. Verfahren zur Herstellung einer Form für eine Uhrenkomponente nach dem vorhergehenden Anspruch, **dadurch gekennzeichnet, dass** der Schritt, der darin besteht, das erste Harz zu belichten (E12), eine erste Struktur erzeugt, die senkrecht oder im Wesentlichen senkrecht zu dem Substrat verlaufende seitliche Flanken und/oder einen parallel oder im Wesentlichen parallel zu dem Substrat verlaufenden konstanten Querschnitt umfasst.

7. Verfahren zur Herstellung einer Form für eine Uhrenkomponente nach einem der vorhergehenden Ansprüche, **dadurch gekennzeichnet, dass**:
- die beiden Harze identisch oder verschieden sind; und/oder
- die beiden Harze positiv oder negativ sind; und/oder
- das erste Harz vom Typ "SU-8" oder vom Typ "SU-8-100" ist; und/oder
- das zweite Harz ein flüssiges oder halbflüssiges Harz ist, insbesondere IP-Dip^{™}.

8. Verfahren zur Herstellung einer Uhrenkomponente, **dadurch gekennzeichnet, dass** es einen Schritt umfasst, der darin besteht, eine Form für eine Uhrenkomponente nach einem der vorhergehenden Ansprüche herzustellen, dann einen Schritt, der darin besteht, die zweite Struktur der Form als Form zur Herstellung der Uhrenkomponente, insbesondere aus Metall oder Metalllegierung, aus Keramik oder aus Verbundmaterial, zu verwenden.

9. Verfahren zur Herstellung einer Uhrenkomponente nach dem vorhergehenden Anspruch, **dadurch gekennzeichnet, dass** es die folgenden Schritte umfasst:
- Abscheiden (E31) einer Metallschicht, die die Uhrenkomponente bildet, durch Elektroabscheidung oder galvanische Abscheidung in der zweiten Struktur;
- Trennen (E32) der Uhrenkomponente, die durch die Metallschicht gebildet wird, und der zweiten Struktur von einem Substrat und Trennen (E33) der Uhrenkomponente, die durch die Metallschicht gebildet wird, von der zweiten Struktur.

10. Verfahren zur Herstellung einer Uhrenkomponente nach dem vorhergehenden Anspruch, **dadurch gekennzeichnet, dass** das Metall auf Nickelbasis ist oder eine Nickel-Phosphor-Legierung ist.

11. Verfahren zur Herstellung einer Uhrenkomponente nach Anspruch 8, **dadurch gekennzeichnet, dass** es die folgenden Schritte umfasst:
- Füllen (E31') der zweiten Struktur auf flüssigem Weg mit einem Produkt, das Keramikpulver umfasst;
- Verfestigen (E32') des Produkts;
- Trennen (E33') des durch das Produkt gebildeten Rohlings von der zweiten Struktur und von einem Substrat;
- Entbindern des im vorherigen Schritt erhaltenen Rohlings, dann Verdichten (E34') desselben durch Sintern.

12. Uhrenkomponente mit zwei horizontalen Oberflächen, umfassend eine strukturierte oder sogar mikrostrukturierte oder nanostrukturierte Oberfläche, die einstückig mit dem Rest der Uhrenkomponente ist und die sich mindestens zum Teil vertieft an einer seitlichen Oberfläche der Uhrenkomponente erstreckt, wobei sie sich zwischen den beiden horizontalen Oberflächen erstreckt, wobei sie ein nicht durchgehendes Muster gemäß der senkrecht zu den horizontalen Oberflächen verlaufenden vertikalen Richtung bildet, **dadurch gekennzeichnet, dass** die strukturierte Oberfläche eine Strukturierung mit einer dreidimensionalen Auflösung kleiner als oder gleich 0,001 µm³ und/oder mit einer seitlichen Auflösung, in der horizontalen Richtung, kleiner als oder gleich 0,1 µm umfasst.

## Claims

1. A method for manufacturing a mold for a horology component, comprising at least the following steps:
- Manufacturing (E1) a first structure (10) from a first photosensitive resin (31) comprising at least one layer of photosensitive resin comprising a first pattern obtained by polymerizing the first photosensitive resin by irradiation through at least one mask (4), then developing said first photosensitive resin;
- Transforming (E2) the first structure (10) into a second structure (1) by structuring at least one surface of the first structure by the addition of a second photosensitive resin (32) to said at least one surface, said second structure (1) being intended to at least partially form a manufacturing mold for said horology component, this step consisting in transforming (E2) the first structure comprising the following steps:
o Applying (E21) a layer of the second photosensitive resin on at least part of the at least one surface of the first structure;
o Performing two-photon polymerization (E22) on the second photosensitive resin in order to obtain three-dimensional polymerization according to a second pattern, using a photon device which comprises an objective which is at least partially immersed in the second resin to direct and focus a beam on voxels that define the shape or the geometry of the second pattern;
o Developing (E23) in order to eliminate the non-polymerized second photosensitive resin and obtain the second structure of a form defined by the first and second patterns.

2. The method for manufacturing a mold for a horology component as claimed in the preceding claim, **characterized in that** the step consisting in transforming (E2) the first structure comprises the addition of the second photosensitive resin on at least one lateral surface (11) of the first structure.

3. The method for manufacturing a mold for a horology component as claimed in one of the preceding claims, **characterized in that** the step consisting in transforming (E2) the first structure comprises the application (E21) of the second photosensitive resin on said at least one surface, the three-dimensional polymerization (E22) of this second resin according to a second pattern, and the developing (E23) of the second resin.

4. The method for manufacturing a mold for a horology component as claimed in claim 2 or 3, **characterized in that** the step consisting in performing two-photon polymerization (E22) makes it possible to define a second pattern with a three-dimensional resolution better than or equal to 0.001 µm³ and/or with a lateral resolution better than or equal to 0.1 µm.

5. The method for manufacturing a mold for a horology component as claimed in one of the preceding claims, **characterized in that** the step consisting in manufacturing (E1) the first structure comprises the following steps:
- Applying (E11) the first photosensitive resin to the upper surface of a substrate, notably a substrate in the form of a wafer made of metal such as stainless steel, or of silicon, or of glass, or of ceramic;
- Exposing (E12) the first photosensitive resin through a mask, notably using a UV radiation, X-radiation or a beam of electrons, in a direction perpendicular or substantially perpendicular to the mask, in order to polymerize it according to the pattern defined by the mask;
- Developing (E13) the first photosensitive resin.

6. The method for manufacturing a mold for a horology component as claimed in the preceding claim, **characterized in that** the step consisting in exposing (E12) the first resin generates a first structure comprising lateral flanks perpendicular or substantially perpendicular to the substrate and/or a constant cross section parallel or substantially parallel to the substrate.

7. The method for manufacturing a mold for a horology component as claimed in one of the preceding claims, **characterized in that**:
- The two resins are identical or different; and/or
- The two resins are positive or negative; and/or
- The first resin is of SU-8 type or of SU-8-100 type; and/or
- The second resin is a liquid or semiliquid resin, notably IP-Dip^{™}.

8. The method for manufacturing a horology component, **characterized in that** it comprises a step consisting in manufacturing a mold for a horology component as claimed in one of the preceding claims, then a step consisting in using the second structure of said mold as a mold for manufacturing the horology component, notably made of metal or metal alloy, of ceramic or of composite material.

9. The method for manufacturing a horology component as claimed in the preceding claim, **characterized in that** it comprises the following steps:
- Using electrodeposition or electroplating to apply (E31) to the second structure a layer of metal that forms the horology component;
- Separating (E32) the horology component, which is formed by said layer of metal, and said second structure of a substrate and separating (E33) the horology component, formed by said layer of metal, from said second structure.

10. The method for manufacturing a horology component as claimed in the preceding claim, **characterized in that** the metal is nickel-based or is a nickel-phosphorus alloy.

11. The method for manufacturing a horology component as claimed in claim 8, **characterized in that** it comprises the following steps:
- Using a liquid route to fill (E31') the second structure with a product containing ceramic powder;
- Consolidating (E32') said product;
- Separating (E33') from said second structure and from a substrate the blank formed by said product;
- Debinding the blank obtained in the preceding step, then densifying it (E34') by sintering.

12. A horology component comprising two horizontal surfaces, comprising a structured, or even microstructured or nanostructured, surface integral with the rest of the horology component and extending at least partially in a recessed manner over a lateral surface of the horology component, extending between the two horizontal surfaces, forming a non continuous pattern in the vertical direction perpendicular to the horizontal surfaces, **characterized in that** the structured surface comprises structuring with a three-dimensional resolution better than or equal to 0.001 µm³ and/or with a lateral resolution, in the horizontal direction, better than or equal to 0.1 µm.
